Europäisches Patentamt

(19) **European Patent Office**

**Office européen des brevets**

(11) Numéro de publication: **0 022 690**
**A1**

(12) **DEMANDE DE BREVET EUROPEEN**

(21) Numéro de dépôt: **80400908.2**

(22) Date de dépôt: **19.06.80**

(51) Int. Cl.³: **H 03 H 9/50**

(30) Priorité: **13.07.79 FR 7918221**

(43) Date de publication de la demande: **21.01.81**
**Bulletin 81/3**

(84) Etats contractants désignés: **CH DE FR GB LI NL SE**

(71) Demandeur: **LIGNES TELEGRAPHIQUES ET TELEPHONIQUES** Société anonyme, 1 Rue Charles Bourseul, F-78702 - Conflans-Ste Honorine (FR)

(72) Inventeur: **Ernyei, Herbert, "THOMSON-CSF"**
**SCPI 173, bld Haussmann, F-75360 Paris Cedex 08 (FR)**

(74) Mandataire: **Benoit, Monique et al, "THOMSON-CSF" - SCPI 173, bld Haussmann, F-75360 Paris Cedex 08 (FR)**

(54) **Cellules de filtre électromécanique et filtre passe-bande les incorporant.**

(57) Chaque cellule élémentaire (23) comporte deux résonateurs cylindriques (2, 3) vibrant longitudinalement et un coupleur cylindrique (11) vibrant en flexion connecté entre les deux résonateurs. Le diamètre du coupleur est défini par la formule:

$$d_c = \sqrt[3]{d_r^2 \cdot \frac{16}{3\pi} \cdot \ell_c \cdot \frac{{}^{10}\alpha_r + (1 - \cos\alpha_c + \mathrm{ch}\alpha_c +)}{\sqrt{\Omega}+ [\sin\alpha_c + \mathrm{sh}\alpha_c + + \cos\alpha_c + \mathrm{ch}\alpha_c + \pm (\sin\alpha_c + + \mathrm{sh}\alpha_c +)]}}$$

De telles cellules s'appliquent aux filtres électromécaniques notamment à large bande.

1

CELLULES DE FILTRE ELECTROMECANIQUE ET
FILTRE PASSE-BANDE LES INCORPORANT

La présente invention concerne des filtres électromécaniques passe-bande, c'est-à-dire des filtres
dont les éléments résonants sont des barreaux cylindriques métalliques (résonateurs), reliés entre-eux
par des éléments de couplage (coupleurs) vibrant suivant un mode choisi et présentant éventuellement des
ponts enjambant un ou plusieurs résonateurs, associés
à un convertisseur électromécanique et un convertisseur inverse, et plus particulièrement des filtres
dont les résonateurs vibrent longitudinalement et les
coupleurs vibrent en flexion. De tels filtres ont fait
l'objet de nombreuses publications. On rappellera, à
titre d'exemple les brevets français n° 2 376 558,
2 389 271 et 2 389 273 déposés par la Demanderesse.

La présente invention a pour objet des cellules
unitaires ou élémentaires de filtre dont la bande passante reproduit avec une grande précision une valeur
fixée à l'avance ainsi qu'un filtre réalisé par mise
en cascade de telles cellules. Dans la pratique, en
effet, le problème posé au réalisateur de filtres consiste à produire le filtre le plus économique, et souvent le plus compact, dont la caractéristique de transfert correspond le mieux à un gabarit donné. Pour cela,
le réalisateur dispose des résultats bien connus d'é-
tudes théoriques qui ont essentiellement porté sur les
filtres électriques et constituent la théorie des
filtres. Les résultats de l'étude du filtre électrique
sont ensuite transposés dans le domaine mécanique par
application d'un système d'équivalence entre grandeurs
électriques et grandeurs mécaniques bien connu de l'homme du métier. Sans entrer dans le détail de la théorie des filtres, il est utile de préciser le sens de certains termes qui seront utilisés dans la suite. La théorie des filtres ramène l'étude du filtre du type désiré (passe-bande polynomial ., par exemple) à celle d'un filtre passe-bas dit filtre prototype. Les cellules électriques de base composant le filtre désiré s'obtiennent à partir du filtre prototype par une transformation mathématique simple (correspondant à un changement de la variable liée à la fréquence). La largeur de bande de la cellule composant le filtre prototype est limitée par la fréquence au-delà de laquelle l'atténuation n'est plus nulle. Par analogie, on définit la largeur de bande d'une cellule de filtre quelconque comme l'intervalle des fréquences transformées des fréquences limitant la bande de la cellule du filtre prototype par le changement de variable mentionné ci-dessus. Dans le cas d'un filtre complet obtenu par mise en cascade de cellules, le plus souvent de même type, la réponse dans la bande passante est définie par le type d'approximation utilisé pour le calcul du filtre (Butterworth, Tschebycheff, etc...) à partir de la caractéristique d'atténuation de l'ensemble du filtre. Celle-ci admet pour butée le gabarit à respecter. Cette dernière condition permet de définir, compte tenu du type d'approximation choisi, le rapport des impédances des branches des cellules du filtre prototype et, grâce à la transformation de la variable, celui des cellules du filtre désiré. L'équivalence électro-mécanique permet alors d'obtenir les grandeurs caractéristiques du filtre mécanique équivalent.

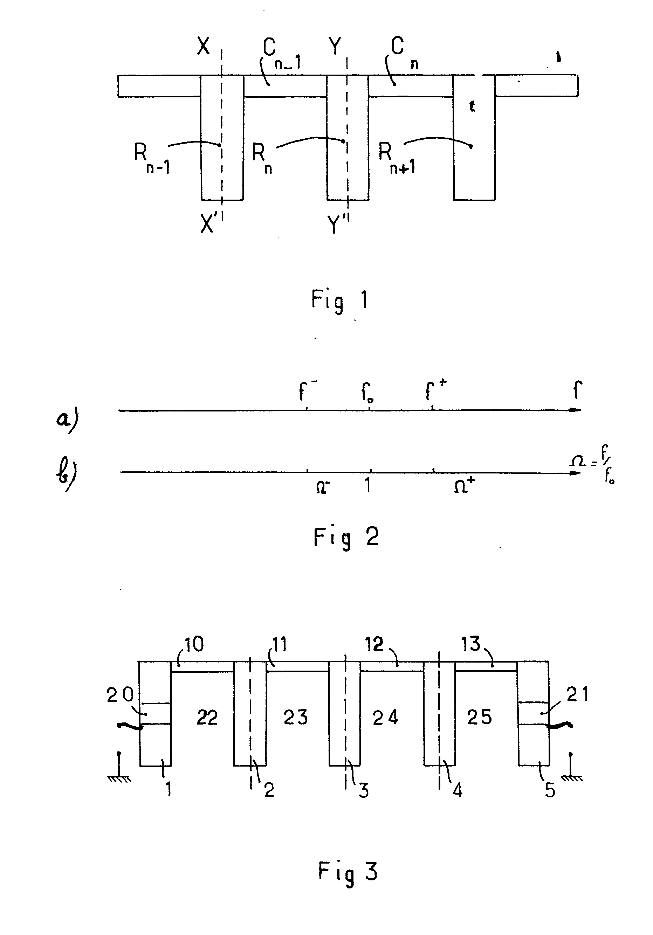

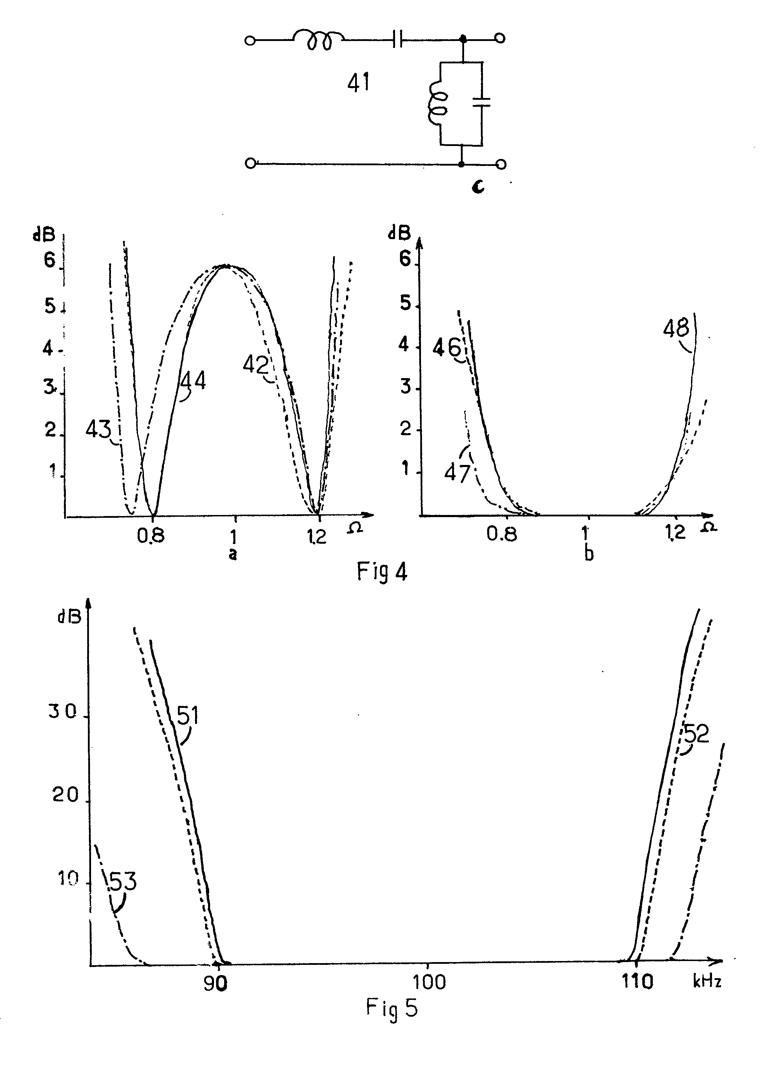

L'article publié par A.E. GUNTHER et al. dans les Proc. of the IEEE (numéro de janvier 1979, page 102) décrit un exemple de filtre mécanique appliqué à un filtre de voie à bande passante relativement large (6%) pour système de transmission téléphonique et montre (figure 4) le schéma électrique de la cellule du filtre électrique correspondant au filtre mécanique, représenté sur la figure 3. Chaque cellule de ce filtre comporte sept composants. Ainsi qu'il est décrit dans l'article cité, des conditions supplémentaires sont imposées par l'industrialisation (identité des barreaux, etc...) qui aboutissent à la définition des paramètres des éléments mécaniques par compromis. Malgré le recours à une cellule électrique de base relativement complexe, la correspondance entre la caractéristique de la cellule du filtre prototype et celle de la cellule du filtre mécanique réalisée n'existe plus au-delà d'une largeur de bande relative supérieure à la valeur de 6% précisée dans l'article. Ce manque de correspondance résulte des approximations qu'il est d'usage de faire en vue d'appliquer le système d'équivalence au niveau de chacune des branches de la cellule. Cette erreur n'est pas gênante dans l'utilisation décrite (largeur de bande relative de quelques centièmes). Dans les autres cas, la différence entre la caractéristique réelle de la cellule mécanique et la caractéristique de la cellule électrique correspondante est importante, ce qui conduit à ajuster les filtres mécaniques réalisés pour les amener en conformité avec le gabarit. De tels réglages sont délicats et onéreux.

La présente invention a essentiellement pour objet des cellules de filtre électromécanique dont la largeur de bande présente la valeur désirée avec une précision élevée. Dans la pratique, l'invention permet de réaliser des filtres même à large bande (largeur de bande relative de plusieurs dixièmes) dont la bande reproduit celle du filtre électrique correspondant avec une précision accrue.

Plus précisément, une cellule unitaire selon l'invention, pour un filtre électromécanique ayant une bande de fréquences à transmettre, comporte :

- deux barreaux cylindriques parallèles formant résonateurs vibrant longitudinalement ; et

- un coupleur cylindrique vibrant en flexion, connecté entre les deux résonateurs ; et le diamètre ($d_c$) du coupleur est défini par la formule :

$$(1) \quad d_c = \sqrt[3]{d_r^2 \cdot \frac{16}{3\pi} \cdot \ell_c \cdot \frac{tg\alpha_r^+ (1 - \cos\alpha_c^+ \, ch\alpha_c^+)}{\sqrt{\Omega^+}[\sin\alpha_c^+ \, sh\alpha_c^+ + \cos\alpha_c^+ ch\alpha_c^+ \pm (\sin\alpha_c^+ + sh\alpha_c^+)]}}$$

où :

$d_r$ est le diamètre des résonateurs

$\ell_c$ est la longueur du coupleur

$\Omega^+ = \dfrac{f^+}{f_o}$ est la fréquence relative supérieure de la bande de fréquences à transmettre, $f^+$ la fréquence supérieure de cette bande et $f_o$ la fréquence d'accord des résonateurs.

$$\alpha_c^+ = \frac{3\pi}{4} \sqrt{\Omega^+} \cdot \frac{\ell_c}{\ell_o} \qquad\qquad \text{avec } \ell_o \text{ la longueur}$$

du coupleur correspondant à un effet quart d'onde

$$\alpha_r^+ = 2\pi n_r \, m \, \Omega^+$$ où m est l'ordre du mode de vibration des résonateurs et où $n_r = \dfrac{\ell_r}{\lambda_0}$ avec $\ell_r$ la longueur des résonateurs et $\lambda_0$ la longueur d'onde à la fréquence fondamentale d'accord des résonateurs en vibration longitudinale.

Les filtres les plus couramment réalisés comportent des coupleurs quart d'onde $\ell_c = \ell_0$ et utilisent des résonateurs demi-onde vibrant sur le mode fondamental $n_r = \frac{1}{2}$ et $m = 1$

on a donc :

$$\alpha_c^+ = \frac{3\pi}{4} \sqrt{\Omega^+}$$

et

$$\alpha_r^+ = \pi\Omega^+$$

D'autres caractéristiques et avantages de l'invention apparaîtront mieux dans la description détaillée qui suit et se réfère aux dessins annexés donnés uniquement à titre d'exemple et dans lesquels :

- les figures 1 et 2 définissent des grandeurs utilisées dans ce qui suit,

- la figure 3 est une représentation schématique d'un exemple de filtre selon l'invention,

- les figures 4 sont des caractéristiques de transfert d'une cellule de filtre selon l'invention chargée par des impédances différentes ,

- la figure 5 représente des caractéristiques de transmission d'un filtre à huit cellules selon l'invention.

La figure 1 permet de préciser ce qui, conformément à l'usage, sera désigné par cellule unitaire ou élémentaire dans la suite de la description. Elle représente d'une façon schématique trois résonateurs intermédiaires d'un filtre, repérés $R_{n-1}$ , $R_n$ , $R_{n+1}$ respectivement couplés par les coupleurs $C_{n-1}$ et $C_n$. La cellule élémentaire de rang n est constituée de la moitié du résonateur $R_{n-1}$, du coupleur $C_{n-1}$, et de la moitié du résonateur $R_n$. Les cellules peuvent être différentes pour obéir aux lois découlant du type d'approximation choisi pour associer les cellules successives constituant le filtre (approximation de Tschebycheff, ou de Butterworth, par exemple) . La cellule élémentaire est figurée entre les axes XX' et YY' sur la figure 1 .

On définit le coefficient de couplage $X_n$ de la cellule élémentaire de rang n par l'expression :

$$x_n = \frac{y_r}{y_{c_{n-1}}} \qquad \text{où} \quad y_r \text{ est la mobilité}$$

de chacune des deux moitiés de résonateur, et $y_{c_{n-1}}$ est la mobilité du coupleur.

La figure 2 représente respectivement en a) et b) l'axe des fréquences f et celui des fréquences relatives $\Omega = f/f_o$ ; $f_o$ est la fréquence centrale du filtre qui doit transmettre les fréquences situées entre $f^-$ et $f^+$ et atténuer les autres fréquences. Ces valeurs sont celles fixées par le calcul à partir de la théorie des filtres. $\Omega^+$ correspond à la valeur relative de la borne supérieure $(f^+/f_o)$ de la bande passante.

La figure 3 représente schématiquement un filtre à cinq résonateurs selon l'invention. On a représenté en 1, 2, 3, 4, 5 les barreaux cylindriques parallèles formant résonateurs vibrant longitudinalement,de longueur $\ell_r$ et de diamètre $d_r$ , reliés entre-eux par des coupleurs cylindriques 10, 11, 12, 13 de longueur $\ell_c$ et de diamètre $d_c$.On a représenté en 20 et 21 les transducteurs électromécaniques d'entrée et de sortie. Le filtre comporte donc quatre cellules élémentaires séparées par des traits pointillés, numérotées respectivement de 22 à 25. Les cellules 22 et 25 sont identiques de même que les cellules 23 et 24, ainsi que l'enseigne la théorie.

La production est avantagée lorsque les conditions suivantes sont remplies :

- uniformité du matériau constituant les coupleurs et les résonateurs ;

- identité des diamètres des coupleurs ou des résonateurs.

Selon une caractéristique essentielle de l'invention, le coefficient de couplage (x) d'une cellule élémentaire obéit à la condition :

$$(2) \quad x = \frac{1}{\sqrt{\Omega^m}} \cdot \frac{\mathrm{tg}\alpha_r^+ \ (1 - \cos\alpha_c^+ \ \mathrm{ch}\alpha_c^+)}{[\sin\alpha_c^+ \ \mathrm{sh}\alpha_c^+ + \cos\alpha_c^+ \ \mathrm{ch}\alpha_c^+ \pm (\sin\alpha_c^+ + \mathrm{sh}\alpha_c^+)]}$$

où les notations correspondent à celles définies pour l'équation (1).

Le signe ± du dénominateur tient compte du fait que x ne peut être négatif quel que soit le mode de vibration (m).

De plus, on sait que le coefficient de couplage x d'une cellule pour un filtre électromécanique est défini par l'expression :

8

$$x = \frac{y_{or}}{y_{oc}}$$ où $y_{or}$ est la mobilité caractéristique des résonateurs et $y_{oc}$ la mobilité caractéristique du coupleur.

Ainsi qu'il est bien connu, la mobilité est inversement proportionnelle à la section droite de l'élément correspondant. Les expressions de $y_{or}$ et $y_{oc}$ sont les suivantes :

$$y_{or} = \frac{1}{p_r \cdot \frac{\pi d_r^2}{4} \cdot v_r}$$

où $p_r$ est la densité du matériau constituant les résonateurs ;
et $v_r$ la vitesse de propagation

$$y_{oc} = \frac{1}{p_c \cdot \frac{\pi d_c^2}{4} \cdot v_c} \cdot \frac{2}{\frac{3\pi}{4} \cdot \frac{d_c}{2\ell_c}}$$

d'où :

$$x = \frac{y_{or}}{y_{oc}} = \frac{p_c \cdot \frac{\pi d_c^2}{4} \cdot v_c}{p_r \cdot \frac{\pi d_r^2}{4} \cdot v_r} \cdot \frac{1}{2} \cdot \frac{3\pi}{4} \cdot \frac{d_c}{2\ell_c}$$

Comme on l'a mentionné précédemment, les coupleurs et les résonateurs sont constitués du même matériau ; d'où $p_r = p_c$ et $v_r = v_c$ .

Dans ces conditions , on a donc :

$$(3) \quad x = \frac{d_c^3}{d_r^2} \cdot \frac{3\pi}{16} \cdot \frac{1}{\ell_c}$$

L'expression définie par l'équation (3) permet de déterminer le diamètre $(d_c)$ des coupleurs . En

effet, le plus souvent, le réalisateur se fixe le diamètre $(d_r)$ des résonateurs afin d'éviter l'existence de modes parasites à des fréquences voisines de la bande transmise. D'autre part, la longueur $(\ell_c)$ des coupleurs est donnée par la condition de couplage que l'on s'impose.

D'après l'équation (3), on a :

$$(4) \qquad d_c = \sqrt[3]{x \cdot d_r^2 \cdot \frac{16}{3\pi} \cdot \ell_c}$$

En tenant compte de l'expression de x donnée par l'équation (2), le diamètre $(d_c)$ des coupleurs donné par l'équation (4) devient :

$$d_c = \sqrt[3]{d_r^2 \cdot \frac{16}{3\pi} \cdot \ell_c \cdot \frac{tg\alpha_r^+ \,(1 - \cos\alpha_c^+ \, ch\alpha_c^+)}{\sqrt{\Omega^+} \,[\sin\alpha_c^+ \, sh\alpha_c^+ + \cos\alpha_c^+ \, ch\alpha_c^+ \pm (\sin\alpha_c^+ + sh\alpha_c^+)]}}$$

Les courbes de la figure 4 représentent les caractéristiques de transfert de cellules unitaires correspondant à la cellule électrique représentée en 41 par la figure 4c, c'est-à-dire, une cellule simple à deux éléments. La courbe 4a correspond à une cellule fermée sur une impédance éloignée de la valeur critique et la courbe 4b à une cellule fermée sur une impédance proche de celle-ci. Les courbes 42 et 46 (en trait interrompu) correspondent à la caractéristique de la cellule issue du filtre prototype, c'est-à-dire à la caractéristique type qui doit être reproduite. Les courbes 43 et 47 (en trait mixte) représentent la caractéristique d'une cellule de filtre mécanique réalisée à partir du modèle 41 par les moyens de l'art antérieur tel que décrit dans l'article de Mr.Bosc publié dans la revue "Câbles et Transmission" numéro 4, 1964 sous le titre "Aperçus sur la technique des fibres électromécaniques". Les courbes 44 et 48 (en trait plein) sont celles de la cellule réalisée selon l'invention à partir du même modèle de la cellule 41, c'est-à-dire une cellule dont les éléments la constituant sont définis par l'équation (1).

On constate que les courbes 44 et 48 sont plus voisines de la courbe type (et la recouvrent même partiellement) que les courbes 43 et 47. La largeur de bande de la cellule de l'invention est très sensiblement celle de la courbe type, alors que ce n'était pas le cas des cellules de l'art antérieur.

La figure 5 représente les mêmes courbes que la figure 4 dans le cas d'un filtre complet à huit cellules.

Comme précédemment, la courbe en trait interrompu 52 est celle du filtre électrique tel que défini par la théorie des filtres, la courbe en trait mixte 53 celle d'un filtre mécanique réalisé suivant l'art antérieur et la courbe en trait plein 51, celle d'un filtre réalisé selon l'invention. Les mêmes améliorations que celles notées sur la figure 4 sont obtenues. La bande passante relative du filtre est de 20 %.

Le filtre est composé de neuf résonateurs constitués de barreaux d'élinvar identiques (diamètre 3,5 mm, longueur 24 mm) vibrant longitudinalement sous l'action de transducteurs constitués de céramiques piézoélectriques de 2,5 mm de diamètre , 3 mm d'épaisseur et de 19 mm de longueur. Les résonateurs sont couplés par des coupleurs de même matériau de longueur identique (1,10 mm) dont les diamètres, différents, sont compris entre 1,38 et 1,42 mm. L'approximation utilisée est celle de Tschebycheff.

La réalisation pratique de filtres électromécaniques à large bande est limitée actuellement par la largeur de bande des transducteurs. L'application de la formule (1) a permis d'étudier des filtres ayant une largeur de bande relative de 40 % , et plus, avec une précision aussi bonne que celle de l'exemple ci-dessus.

12

## REVENDICATIONS

1 - Cellule unitaire pour un filtre électro-mécanique ayant une bande de fréquences à transmettre, comportant :

- deux barreaux cylindriques parallèles formant résonateurs (2,3) vibrant longitudinalement ; et

- un coupleur cylindrique (11) vibrant en flexion connecté entre les deux résonateurs ;

caractérisée en ce que le diamètre du coupleur ($d_c$) est défini par la formule :

$$d_c = \sqrt[3]{d_r^2 \cdot \frac{16}{3\pi} \cdot \ell_c \cdot \frac{tg\alpha_r^+ \, (1 - \cos\alpha_c^+ \, ch\alpha_c^+)}{\sqrt{\Omega^+} \, [\sin\alpha_c^+ \, sh\alpha_c^+ + \cos\alpha_c^+ \, ch\alpha_c^+ \pm (\sin\alpha_c^+ + sh\alpha_c^+)]}}$$

où

$d_r$ est le diamètre des résonateurs

$\ell_c$ est la longueur du coupleur

$\Omega^+ = \dfrac{f^+}{f_o}$ est la fréquence relative supérieure de la bande de fréquences à transmettre, avec $f^+$ la fréquence supérieure de cette bande et $f_o$ la fréquence d'accord des résonateurs

$\alpha_c^+ = \dfrac{3\pi}{4} \sqrt{\Omega^+} \cdot \dfrac{\ell_c}{\ell_o}$ avec $\ell_o$ la longueur du coupleur correspondant à un effet quart d'onde

13

$\alpha_r{}^+ = 2\pi \; n_r \; m \; \Omega^+$ où m est l'ordre du mode de vibration des résonateurs et où $n_r = \dfrac{\ell_r}{\lambda_o}$ avec $\ell_r$ la longueur des résonateurs et $\lambda_o$ la longueur d'onde à la fréquence fondamentale d'accord des résonateurs en vibration longitudinale.

2 - Filtre électromécanique comportant une cascade de cellules unitaires selon la revendication 1 associées à des transducteurs électromécaniques (20, 21) d'entrée et de sortie.

Fig 1

a)

b)

Fig 2

Fig 3

Fig 4

Fig 5

**Office européen des brevets**

**RAPPORT DE RECHERCHE EUROPEENNE**

0022690

Numéro de la demande

EP 80 40 0908

## DOCUMENTS CONSIDERES COMME PERTINENTS

| Catégorie | Citation du document avec indication, en cas de besoin, des parties pertinentes | Revendication concernée |
|---|---|---|
| DA | FR - A - 2 376 558 (LTT) <br> * En entier * <br><br> -- | 1,2 |
| DA | FR - A - 2 389 271 (LTT) <br> * En entier * <br><br> -- | 1,2 |
| DA | FR - A - 2 389 273 (LTT) <br> * En entier * <br><br> ---- | 1,2 |

**CLASSEMENT DE LA DEMANDE (Int. Cl. 3)**

H 03 H 9/50

**DOMAINES TECHNIQUES RECHERCHES (Int. Cl. 3)**

H 03 H 9

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

Le présent rapport de recherche a été établi pour toutes les revendications

| Lieu de la recherche | Date d'achèvement de la recherche | Examinateur |
|---|---|---|
| La Haye | 30-09-1980 | DECONINCK |

OEB Form 1503.1   06.78